# FASCICULE DE BREVET EUROPEEN

(11) **EP 3 227 933 B1**
(45) Date de publication et mention de la délivrance du brevet: **27.02.2019**
(21) Numéro de dépôt: 15813289.4
(22) Date de dépôt: 03.12.2015
(51) Int. Cl.: H01L 51/00, H01L 51/44, H01L 27/30

(54) **PROCEDE POUR RECOUVRIR UNE COUCHE D'OXYDE TRANSPARENT CONDUCTEUR D'UNE COUCHE CONTINUE DE MATERIAU CONDUCTEUR**
VERFAHREN ZUM ABDECKEN EINER SCHICHT AUS LEITFÄHIGEM TRANSPARENTEN OXID MIT EINER KONTINUIERLICHEN SCHICHT AUS LEITENDEM MATERIAL
METHOD FOR COVERING A LAYER OF CONDUCTIVE TRANSPARENT OXIDE WITH A CONTINUOUS LAYER OF CONDUCTIVE MATERIAL

(30) Priorité: 03.12.2014 FR 1461849
(43) Date de publication de la demande: 11.10.2017
(73) Titulaire: Commissariat à l'Énergie Atomique et aux Énergies Alternatives, 75015 Paris (FR)
(72) Inventeur: BOUILLARD, Boris, 73000 Chambery (FR); MANCEAU, Matthieu, 74000 Annecy (FR); SOUMAIRE, Clément, 73370 Le Bourget-du-Lac (FR)
(74) Mandataire: Nony
(86) Numéro de dépôt international: PCT/EP2015/078556
(87) Numéro de publication internationale: WO 2016/087599

(56) Documents cités:
- WO-A1-2009/103705
- US-A1- 2006 032 529
- US-A1- 2006 169 973
- RAND BARRY ET AL: "Long-range absorption enhancement in organic tandem thin-film solar cells containing silver nanoclusters", JOURNAL OF APPLIED PHYSICS, AMERICAN INSTITUTE OF PHYSICS, US, vol. 96, no. 12, 15 décembre 2004 (2004-12-15), pages 7519-7526, XP012068491, ISSN: 0021-8979, DOI: 10.1063/1.1812589
- KAWANO KENJI ET AL: "Open circuit voltage of stacked bulk heterojunction organic solar cells", APPLIED PHYSICS LETTERS, AMERICAN INSTITUTE OF PHYSICS, 2 HUNTINGTON QUADRANGLE, MELVILLE, NY 11747, vol. 88, no. 7, 17 février 2006 (2006-02-17), pages 73514-073514, XP012082923, ISSN: 0003-6951, DOI: 10.1063/1.2177633

## Description

La présente invention se rapporte à un nouveau procédé pour recouvrir une couche d'oxyde transparent conducteur (TCO) d'une couche continue de matériau conducteur telle qu'une couche d'argent.

La formation d'un dépôt continu de matériau conducteur, en particulier d'argent, sur le TCO est plus particulièrement utile pour la réalisation des contacts électriques au sein de dispositifs électroniques organiques, par exemple des dispositifs photovoltaïques organiques (OPV). Par exemple, elle intervient pour former la zone, dite de « reprise de contact » d'interconnexion électrique entre deux cellules adjacentes dans un module photovoltaïque organique.

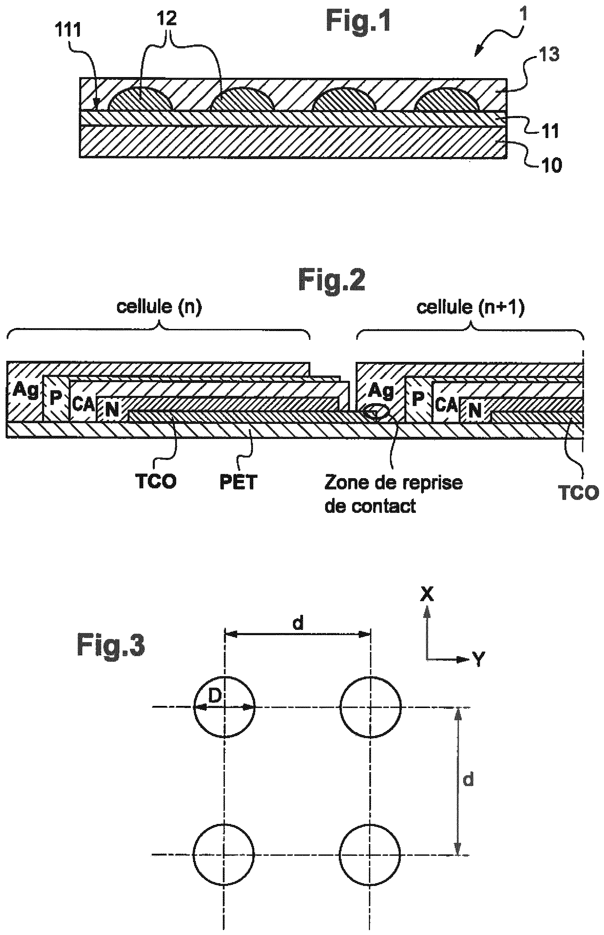

Dans le cas particulier d'un module OPV en structure dite « inverse », également appelée structure « NIP », comme représenté schématiquement en figure 2, cette zone de reprise de contact correspond à l'empilement de l'électrode supérieure, typiquement en argent, de la cellule (n+1) du module avec l'électrode inférieure en TCO de la cellule (n).

Malheureusement, il est difficile, du fait des propriétés respectives de l'encre argent et de la couche TCO, d'accéder à une impression de qualité du matériau conducteur sur le TCO.

Pour pallier ce défaut, différentes techniques ont déjà été proposées.

Une première technique consiste en la formation d'une couche, intermédiaire entre le TCO et l'argent, à base de chrome et d'or (Perrier et al., Solar Energy Materials and Solar Cells 2012, Volume 101, pages 210-216). Plus précisément, une première fine couche de chrome et une seconde couche d'or, d'épaisseurs respectives de 10 et 40 nm, sont formées successivement par évaporation sous vide. Le dépôt de cette couche intermédiaire par évaporation permet avantageusement d'augmenter la mobilité des charges dans cette zone de transition (gain électrique) et favorise l'obtention d'un dépôt homogène en argent, notamment en raison de la très faible rugosité de la couche formée par évaporation.

Toutefois, outre le fait que ce procédé requiert des étapes supplémentaires, cette technique présente un désavantage majeur du fait de la réalisation des couches intermédiaires de chrome et d'or sous vide secondaire, ce qui la rend difficilement exploitable à l'échelle industrielle.

La seconde technique consiste en un traitement de surface du TCO, par exemple de type UV-ozone, « Corona » ou plasma (Perrier et al., Solar Energy Materials and Solar Cells 2012, Volume 101, pages 210-216). Un tel traitement de surface permet d'homogénéiser la surface du TCO et de la rendre plus hydrophile, favorisant ainsi une meilleure mouillabilité de l'argent.

Malheureusement, en plus de nécessiter la mise en oeuvre d'un traitement spécifique additionnel, et donc d'un équipement supplémentaire, ces traitements ont tendance, par exemple dans le cadre de la réalisation des reprises de contact dans un module OPV, à endommager certaines couches du dispositif photovoltaïque, en particulier la couche active et la couche semi-conductrice P. Tout traitement de surface de ce type est donc impossible après dépôt de ces couches, et doit donc avoir lieu en début de procédé. Toutefois, les effets de ces traitements de surface n'étant pas permanents, l'impression des reprises de contact doit avoir lieu immédiatement après leur application. Par conséquent, deux étapes d'impression de l'électrode supérieure en argent sont nécessaires : une première impression en début de procédé après le traitement de surface pour réaliser les reprises de contact, et une seconde impression en fin de procédé pour former l'électrode supérieure.

US2006/169973 A1 concerne un procédé simplifié de fabrication d'un dispositif semi-conducteur ou d'un dispositif d'affichage. En particulier, ce document décrit un procédé permettant l'obtention d'une couche d'une forme souhaitée, par exemple une couche conductrice, sur un substrat donné à l'aide de plusieurs étapes de dépôt d'une composition sous forme de gouttes.

US2006/032529 A1 et RAND BARRY ET AL: JOURNAL OF APPLIED PHYSICS, vol. 96, no. 12, 15 décembre 2004, pages 7519-7526 divulguent une cellule solaire organique de type tandem, dans laquelle les deux cellules sont mises en contact par une anode en ITO et une cathode en Ag, et séparées par une couche de nanoparticules d'Ag.

KAWANO KENJI ET AL: APPLIED PHYSICS LETTERS, vol. 88, no. 7, 17 février 2006, pages 73514-073514 divulgue aussi une cellule solaire organique de type tandem avec une couche intermédiaire en ITO, ladite intermédiaire étant déposée par pulvérisation cathodique magnétron à courant continu sans chauffage du substrat.

WO2009/103705 A1 divulgue aussi une cellule solaire organique de type tandem avec nanoparticules en ZnO entre les deux cellules.

En conséquence, il serait avantageux de disposer d'un nouveau procédé pour recouvrir une couche de TCO d'une couche continue de matériau conducteur, telle qu'une couche d'argent, en particulier utile pour réaliser les reprises de contact dans les modules OPV, et ne présentant pas les inconvénients évoqués précédemment.

La présente invention vise précisément à proposer un nouveau procédé donnant satisfaction aux exigences précitées.

Plus particulièrement, la présente invention concerne, selon un premier de ses aspects, un procédé pour recouvrir une couche d'oxyde transparent conducteur (TCO) d'une couche continue de matériau conducteur choisi parmi l'argent, le cuivre, l'or, l'aluminium et leurs mélanges, comprenant au moins les étapes consistant à :
(i) disposer d'une couche d'oxyde transparent conducteur ;
(ii) constituer, à la surface de ladite couche, une pluralité d'amas de matériau (M) *via* les étapes consécutives suivantes :
   (a) dépôt de gouttes régulièrement réparties sur ladite surface, l'espacement entre deux gouttes voisines étant ajusté pour que les gouttes en s'étalant ne coalescent pas ;
      lesdites gouttes étant formées d'un milieu liquide comprenant un matériau (M) dans un ou plusieurs solvants et présentant une bonne mouillabilité vis-à-vis de l'oxyde transparent conducteur de la couche inférieure et vis-à-vis du matériau conducteur destiné à former la couche continue supérieure ;
      une bonne mouillabilité dudit milieu liquide vis-à-vis d'un matériau donné s'entendant d'un angle de contact, d'une goutte dudit milieu liquide déposée sur un support en ledit matériau, strictement inférieur à 90° ; et
   (b) évaporation du ou desdits solvants contenu(s) dans les gouttes déposées pour former lesdits amas de matériau (M) ;
   le taux de recouvrement de la surface de ladite couche d'oxyde transparent conducteur par lesdits amas de matériau (M) étant ajusté pour garantir la formation d'une couche supérieure continue en matériau conducteur ; et
(iii) former à la surface de l'ensemble obtenu à l'issue de l'étape (ii) ladite couche de matériau conducteur souhaitée.

Les amas de matériau (M), résultant de l'étalement des gouttes lors de leur dépôt et de l'évaporation du ou des solvants des gouttes, se présentent plus particulièrement sous la forme de disques ou « gouttes étalées ». Ces amas de matériau (M) sont désignés dans la suite du texte sous l'appellation plus courante, en langue anglaise, de « splats ».

Par ailleurs, on parlera dans la suite du texte, de « précouche d'interconnexion » ou, plus simplement, de « précouche », pour désigner l'ensemble des amas (« splats ») formés à la surface de la couche d'oxyde transparent conducteur.

Les inventeurs ont ainsi découvert que l'intégration d'une telle précouche de splats de matériau (M) selon l'invention, distribués de manière adéquate à la surface de la couche TCO, permet d'améliorer significativement la mouillabilité du matériau conducteur tel que l'argent sur le TCO, et d'accéder à un dépôt continu, en particulier homogène, de matériau conducteur en surface de la couche TCO, sans recourir à des traitements de surface.

Le procédé selon l'invention s'avère particulièrement utile pour la réalisation des contacts électriques au sein d'un dispositif électronique organique, notamment pour former les reprises de contact entre les cellules d'un module photovoltaïque organique (OPV).

De manière avantageuse, l'intégration d'une précouche selon l'invention peut être aisément mise en oeuvre à l'échelle industrielle et ne nécessite pas d'équipement supplémentaire pour l'élaboration du dispositif électronique organique, étant donné que la précouche de splats selon l'invention peut être réalisée par une technique de dépôt simple, de préférence par impression jet d'encre, technique déjà usuellement employée pour l'impression d'une ou plusieurs des couches entrant dans la composition du dispositif électronique organique, par exemple pour l'impression de la couche semi-conductrice P et de l'électrode supérieure dans le cas d'un module OPV.

Qui plus est, comme détaillé dans la suite du texte, lorsque le matériau (M) est choisi de nature identique à l'un des matériaux utilisés pour l'une des autres couches du dispositif électronique organique, la précouche selon l'invention peut être réalisée en même temps que la couche correspondante, ce qui pour des raisons évidentes, est particulièrement avantageux d'un point de vue pratique (gain de temps) et financier.

Enfin, la mise en oeuvre d'une précouche selon l'invention sous forme de splats permet d'assurer un bon contact électrique entre la couche de matériau conducteur et la couche TCO, quelle que soit la conductivité électrique du matériau (M) utilisé. Comme illustré dans les exemples 4 et 5 qui suivent dans le cas de la réalisation d'un module OPV, le procédé de l'invention permet ainsi d'accéder à un bon contact électrique entre les différentes cellules du module.

La présente invention concerne encore, selon un autre de ses aspects, une structure multicouche, telle qu'obtenue à l'issue du procédé selon l'invention, présentant une couche d'oxyde transparent conducteur surmontée d'une couche supérieure continue de matériau conducteur choisi parmi l'argent, le cuivre, l'or, l'aluminium et leurs mélanges, caractérisée en ce que des amas de matériau (M) sont régulièrement répartis sur la face de contact de ladite couche d'oxyde transparent conducteur avec la couche supérieure,
le matériau (M) étant tel qu'un milieu liquide comprenant ledit matériau (M) dans un ou plusieurs solvants présente une bonne mouillabilité vis-à-vis de l'oxyde transparent conducteur formant ladite couche inférieure et vis-à-vis du matériau conducteur formant la couche continue supérieure ; une bonne mouillabilité dudit milieu liquide vis-à-vis d'un matériau donné s'entendant d'un angle de contact, d'une goutte dudit milieu liquide déposée sur un support en ledit matériau, strictement inférieur à 90° ;
le taux de recouvrement de la surface de la couche d'oxyde transparent conducteur par lesdits amas (12) étant compris entre 2 et 90 %, en particulier entre 7 et 80 %.

D'autres caractéristiques, variantes et avantages du procédé de l'invention ressortiront mieux à la lecture de la description et des exemples qui vont suivre, donnés à titre illustratif et non limitatif, et à l'examen des dessins annexés, sur lesquels :
- la figure 1 représente, de manière schématique, dans un plan vertical de coupe, une structure multicouche formée selon l'invention ;
- la figure 2 représente, de manière schématique, en vue de coupe, l'architecture de deux cellules connectées en série dans un module photovoltaïque organique en structure dite « inverse » (NIP) ;
- la figure 3 représente, de manière schématique, en vue de dessus, la disposition des splats selon un maillage carré ;
- la figure 4 représente, de manière schématique, en vue de coupe, la zone de reprise de contact d'un module OPV, pour une précouche formée du matériau formant la couche semi-conductrice N (figure (a)) et du matériau formant la couche semi-conductrice P (figure (b)) ; et
- la figure 5 représente les images, obtenues au microscope optique sous lumière blanche, des dépôts d'argent réalisés selon l'exemple 1, sans formation de splats (figure (a)), avec formation de splats de ZnO, de diamètre D de 140 µm et espacés d'une distance d de 140 µm (figure (b)) et avec formation de splats de ZnO, de diamètre D de 140 µm et espacés d'une distance d de 200 µm (figure (c)).

Il convient de noter que, pour des raisons de clarté, les différents éléments sur les figures 1 à 4 sont représentés en échelle libre, les dimensions réelles des différentes parties n'étant pas respectées.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

### PROCEDE POUR RECOUVRIR UNE COUCHE TCO D'UNE COUCHE CONTINUE DE MATERIAU CONDUCTEUR

### ETAPE (i) : COUCHE D'OXYDE TRANSPARENT CONDUCTEUR

Comme précisé précédemment, l'étape (i) du procédé de l'invention consiste à disposer d'une couche d'oxyde transparent conducteur (« TCO » pour l'appellation en langue anglaise « Transparent Conductive Oxide »), désignée plus simplement par la suite « couche TCO ».

Le TCO peut être plus particulièrement choisi parmi l'oxyde d'indium dopé à l'étain (« ITO » pour l'appellation en langue anglaise « Indium Tin Oxide » ou « Tin-doped Indium Oxide ») et l'oxyde de zinc éventuellement dopé.

Selon un mode de réalisation particulier, il s'agit d'oxyde d'indium dopé à l'étain.

La couche TCO peut par exemple présenter une épaisseur comprise entre 50 et 1 000 nm, en particulier entre 100 et 500 nm.

Dans le cas particulier de la mise en oeuvre du procédé de l'invention pour former la reprise de contact entre deux cellules adjacentes d'un module photovoltaïque organique (OPV), la couche TCO peut former une des électrodes d'une cellule OPV, par exemple l'électrode inférieure dans un module OPV en structure dite « inverse », comme illustré en figure 2.

La couche TCO est généralement supportée par un substrat. Le terme « substrat » fait référence à une structure de base solide, sur une des faces de laquelle est formée la couche TCO considérée selon l'invention.

Le substrat peut être par exemple en polyester, en particulier en polyéthylène téréphtalate (PET), en polyéthylène naphtalate ou en polycarbonates.

Bien entendu, la nature du substrat dépend là encore du dispositif électronique organique (photovoltaïque, diode électroluminescente, etc.) visé.

La couche TCO peut être formée en surface du substrat de base par des techniques connues de l'homme du métier, en particulier par dépôt physique en phase vapeur (PVD) ou dépôt chimique en phase vapeur (CVD).

### ETAPE (ii) : PRECOUCHE SELON L'INVENTION

Selon une seconde étape du procédé de l'invention, il est formé, à la surface de la couche TCO, une pluralité d'amas de matériau (M), désignés par la suite sous l'appellation plus courante « splats ».

Ces splats sont plus particulièrement formés par les étapes successives suivantes :
(a) dépôt de gouttes formées d'un milieu liquide comprenant le matériau (M) dans un ou plusieurs solvants ; et
(b) évaporation du ou desdits solvants contenus dans les gouttes déposées pour former lesdits splats.

Il convient de choisir la nature du matériau (M) parmi les matériaux imprimables présentant à la fois une affinité chimique vis-à-vis du TCO et du matériau conducteur destiné à former la couche supérieure souhaitée.

Plus précisément, le milieu liquide comprenant le matériau (M) et un ou plusieurs solvants, déposé sous forme de gouttes en étape (a), doit présenter une bonne mouillabilité, d'une part vis-à-vis du TCO de la couche inférieure à la surface de laquelle sont déposées lesdites gouttes et, d'autre part, vis-à-vis du matériau conducteur destiné à former la couche continue supérieure souhaitée.

Par « bonne mouillabilité » vis-à-vis d'un matériau donné (TCO ou matériau conducteur), on désigne, au sens de l'invention, l'aptitude du milieu liquide à être déposé sous forme de gouttes à la surface d'un support constitué dudit matériau donné, en formant un angle de contact, dit encore angle de mouillage, strictement inférieur à 90°.

La détermination de l'angle de contact se fait, de manière connue de l'homme du métier, par mesure de l'angle θ entre la tangente à la goutte déposée sur le support au point de contact et la surface plane du support solide sur laquelle est déposée la goutte.

L'homme du métier est à même de choisir de manière adéquate la nature du milieu liquide au regard de la nature de la couche TCO et de la couche de matériau conducteur à former, pour satisfaire aux conditions de mouillabilité énoncées ci-dessus.

Dans le cas de la mise en oeuvre du procédé de l'invention pour réaliser un contact électrique au sein d'un dispositif électronique organique, le matériau (M) est choisi, si possible, pour des raisons pratiques évidentes, parmi les matériaux déjà mis en oeuvre dans la conception du dispositif électrique.

Par exemple, dans le cas de la formation des reprises de contact entre les cellules adjacentes d'un module OPV, le matériau (M) est avantageusement choisi parmi les matériaux déjà utilisés pour les autres couches entrant dans la conception du module OPV. La précouche selon l'invention peut être ainsi réalisée en même temps que la couche correspondante formée du même matériau (M).

Selon un mode de réalisation particulier, le matériau (M) selon l'invention peut être choisi parmi :
- l'argent en particulier sous forme de nanoparticules (matériau pouvant constituer l'électrode supérieure dans le cadre d'un module OPV en structure inverse) ;
- l'oxyde de zinc (ZnO) en particulier sous forme de nanoparticules (matériau pouvant constituer la couche semi-conductrice N dans un module OPV en structure inverse) ; et
- les polymères de type PEDOT : PSS (matériau pouvant constituer la couche semi-conductrice P dans un module OPV en structure inverse).

Les polymères de type PEDOT : PSS comprennent :
- du poly(3,4-EthylèneDiOxyThiophène) ou PEDOT de structure chimique : 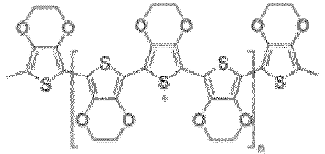 avec n un nombre entier positif ; et
- du PolyStyrèneSulfonate ou PSS sous forme protonée (à droite) ou non (à gauche), de structure chimique : 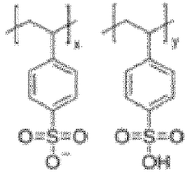 avec x et y des nombres entiers positifs.

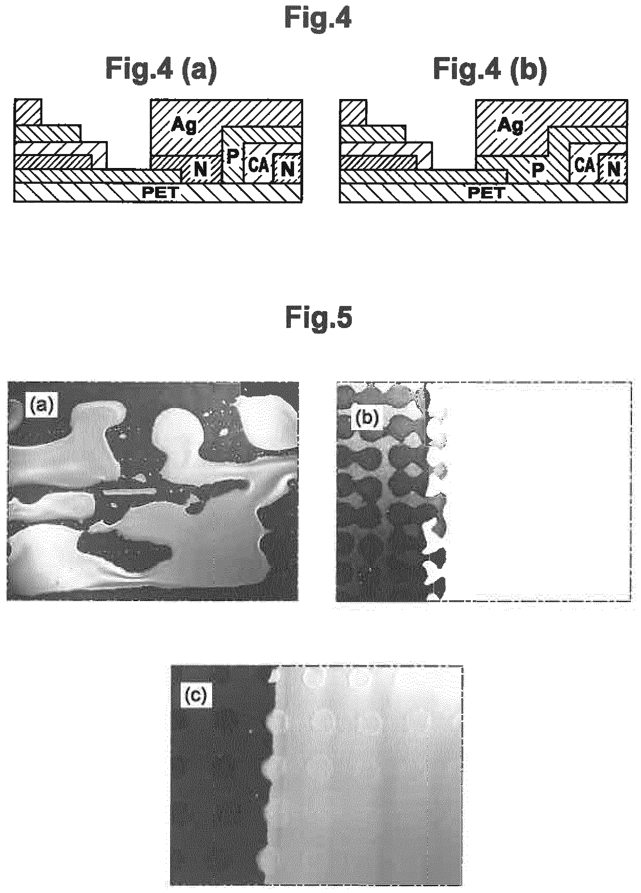

A titre d'exemple, la zone de reprise de contact d'un module OPV en structure dite inverse (connexion de l'électrode inférieure TCO de la cellule (n) et de l'électrode supérieure en argent de la cellule (n+1)), est représentée de manière schématique en figure 4, pour une précouche formée du matériau constituant la couche semi-conductrice N (figure 4(a)) et pour une précouche formée du matériau constituant la couche semi-conductrice P (figure 4(b)).

Le milieu liquide déposé sous forme de gouttes à la surface de la couche TCO correspond à une « encre ». Il comprend le matériau (M) dans un ou plusieurs solvants, en particulier choisis parmi l'eau, les alcools ou diols.

Le milieu liquide peut être par exemple une dispersion de nanoparticules d'argent ou d'oxyde de zinc, dans un ou plusieurs solvants de type alcool ou diol (par exemple, éthanol, éthylène glycol ou leur mélange).

Il peut encore s'agir d'une suspension de matrice polymère de type PEDOT : PSS dans un solvant aqueux, en particulier dans l'eau.

Plusieurs gouttes peuvent être déposées simultanément à la surface de la couche TCO.

Le dépôt des gouttes en étape (a) du procédé de l'invention peut être opéré par pulvérisation (« spray-coating » en langue anglaise) ou impression par jet d'encre.

Selon un mode de réalisation préféré, le dépôt des gouttes est opéré par impression jet d'encre.

Cette technique est bien connue de l'homme du métier et déjà usuellement mise en oeuvre pour former une ou plusieurs des couches d'un dispositif électronique organique, par exemple la couche semi-conductrice P et l'électrode supérieure dans un module OPV.

Le dépôt des gouttes peut être réalisé à l'aide d'un dispositif à jet d'encre conventionnel, comportant notamment une ou plusieurs têtes d'impression munies d'une ou plusieurs buses d'éjection.

L'impact de la goutte en surface de la couche TCO provoque son étalement, généralement sous forme de disque.

Le séchage entraînant l'évaporation du ou des solvants contenu(s) dans les gouttes déposées conduit aux amas ou « splats » de matériau (M).

Le séchage peut être opéré en exposant la surface de la couche TCO sur laquelle ont été déposées les gouttes, à une température comprise entre 50 et 250 °C, en particulier entre 100 et 140 °C. La durée du séchage peut être comprise entre 10 secondes et 10 minutes. Le séchage est par exemple opéré par application d'un traitement thermique *via* une plaque chauffante.

Le séchage peut aussi être réalisé par exemple par application d'un rayonnement infra-rouge ou dans une étuve.

Selon le procédé de l'invention, l'agencement des splats répartis à la surface de la couche TCO est ajusté pour répondre aux deux critères suivants.

D'une part, il est impératif que les gouttes déposées, en s'étalant après impact sur la surface de la couche TCO, ne coalescent pas.

Il convient ainsi d'ajuster l'espacement entre les gouttes déposées pour éviter leur coalescence.

On parle de « coalescence » des gouttes lorsque les gouttes déposées côte à côte, en s'étalant, se réunissent (du fait notamment de la tension superficielle des gouttes et éventuellement de leur mobilité sur le substrat à la surface duquel elles sont déposées).

D'autre part, le taux de recouvrement de la surface de la couche TCO par les amas de matériau (M) formés est ajusté pour garantir la formation d'une couche supérieure continue en matériau conducteur.

Par « taux de recouvrement », on entend au sens de l'invention la proportion de la surface occupée par les splats sur la surface totale traitée de la couche TCO.

De fait, comme illustré dans les exemples qui suivent, un taux de recouvrement insuffisant ne permettrait pas d'assurer le dépôt ultérieur d'une couche continue de matériau conducteur.

Par ailleurs, il est préférable que le taux de recouvrement de la surface de la couche TCO par les splats ne soit pas trop important pour permettre un contact électrique optimal entre la couche TCO et la couche supérieure de matériau conducteur, en particulier lorsque le matériau (M) formant les splats n'est pas conducteur électrique.

Selon un mode de réalisation particulier, l'agencement des splats est ajusté pour atteindre le plus faible taux de recouvrement permettant d'accéder au dépôt d'une couche continue de matériau conducteur.

De préférence, le taux de recouvrement de la surface de la couche TCO par les splats est compris entre 2 et 90 %, en particulier entre 7 et 80 %.

Les splats formés selon l'invention peuvent être disjoints ou adjacents, pour autant que le taux de recouvrement souhaité est atteint.

L'homme du métier est à même d'adapter l'agencement des gouttes déposées, et donc des splats formés après évaporation du ou des solvants, en particulier *via* le contrôle de l'espacement (d) et du diamètre moyen (D) des splats formés, pour satisfaire aux critères précités.

Selon un mode de réalisation particulier, les splats sont disposés à la surface de la couche TCO de manière répétitive.

De préférence, ils sont régulièrement espacés le long de deux axes orthogonaux (X) et (Y) d'une distance (d) pour former un maillage carré comme représenté en figure 3.

L'espacement (d) s'entend de la distance centre à centre, encore appelé « pas », entre deux splats successifs. Il correspond encore à l'espacement entre les gouttes déposées.

L'espacement (d) peut être par exemple prédéterminé par l'écartement entre les buses de la tête d'impression du dispositif à jet d'encre utilisé et son orientation lors du dépôt des gouttes.

Le diamètre moyen (D) s'entend du diamètre de la surface de contact du splat (obtenu après évaporation du ou des solvants contenu(s) dans la goutte déposée) avec la couche TCO. Il peut être déterminé par observation par microscopie optique de la surface TCO à sur laquelle sont formés les splats.

Le diamètre moyen des splats formés dépend notamment du volume des gouttes déposées en étape (a) à la surface de la couche TCO, de la concentration de ces gouttes en matériau (M) ainsi que du substrat et notamment de son énergie de surface.

Les gouttes peuvent présenter un volume compris entre 1 pL et 100 pL, en particulier de 5 pL et 80 pL et plus particulièrement entre 10 pL et 50 pL.

Le volume des gouttes peut être contrôlé par les paramètres du dispositif à jet d'encre utilisé pour déposer les gouttes, par exemple le diamètre de l'orifice de la buse d'éjection.

D'une manière générale, la distance (d), centre à centre, entre deux amas de matériau (M) voisins, peut être comprise entre 20 µm et 200 µm, en particulier entre 25 µm et 150 µm. Leur diamètre (D) peut être compris entre 20 µm et 200 µm, en particulier entre 25 µm et 150 µm.

Selon une variante de réalisation, dans le cas où le matériau (M) est l'argent, la disposition des amas de matériau (M) peut être la suivante :
- diamètre moyen (D) des amas de matériau (M) compris entre 20 et 100 µm, en particulier entre 25 et 50 µm, et
- distance (d), centre à centre, entre deux amas voisins comprise entre 50 et 100 µm, en particulier entre 75 et 100 µm.

Selon une autre variante de réalisation, dans le cas où le matériau (M) est l'oxyde de zinc, la disposition des amas de matériau (M) peut être la suivante :
- diamètre moyen (D) des amas de matériau (M) compris entre 20 et 200 µm, en particulier entre 50 et 150 µm; et
- distance (d), centre à centre, entre deux amas voisins comprise entre 50 et 200 µm, en particulier entre 100 et 200 µm.

Selon encore une autre variante de réalisation, dans le cas où le matériau (M) est un polymère de type PEDOT : PSS, la disposition des amas de matériau (M) peut être la suivante :
- diamètre moyen (D) des amas de matériau (M) compris entre 20 et 100 µm, de préférence entre 40 et 80 µm, en particulier entre 50 et 80 µm ; et
- distance (d), centre à centre, entre deux amas voisins comprise entre 20 et 200 µm, en particulier entre 50 et 80 µm.

### ETAPE (iii): FORMATION D'UNE COUCHE CONTINUE DE MATERIAU CONDUCTEUR

Selon une troisième étape du procédé de l'invention, il est formé à la surface de l'ensemble obtenu à l'issue de l'étape (ii) décrite précédemment, la couche continue en matériau conducteur souhaité.

Il est entendu que la surface de l'ensemble obtenu à l'issue de l'étape (ii) s'entend de la surface externe des splats formés et de la surface laissée libre entre les splats de la couche TCO.

Par couche « continue », on entend au sens de l'invention un revêtement se présentant sous la forme d'un film non interrompu.

La couche de matériau conducteur peut être une couche d'argent, de cuivre, d'or, d'aluminium ou des mélanges de ces matériaux.

Selon un mode de réalisation particulier, il s'agit d'une couche d'argent.

La couche de matériau conducteur peut être réalisée plus particulièrement par une technique d'impression par jet d'encre, suivie d'une étape de séchage.

A la différence de l'impression décrite précédemment pour former les splats selon l'invention, l'espacement entre les gouttes pulvérisées pour former la couche de matériau conducteur est plus faible de manière à ce que les gouttes coalescent pour former la couche continue attendue.

La couche continue de matériau conducteur, en particulier d'argent, peut présenter une épaisseur comprise entre 100 et 2 000 nm, en particulier entre 200 et 1 000 nm.

Selon un mode de réalisation particulier, la couche continue de matériau conducteur ainsi formée présente une épaisseur homogène.

Par « épaisseur homogène », on entend que l'épaisseur ne varie pas plus de 20 %, de préférence de 10 % sur l'ensemble de la surface de ladite couche de matériau conducteur.

On a représenté en figure 1, de manière schématique, en vue de coupe, une structure multicouche (1) obtenue à l'issue du procédé selon l'invention.

Dans la structure illustrée, la couche d'oxyde conducteur transparent (11), par en oxyde d'indium dopé à l'étain (ITO), est supportée par un substrat de base, par exemple en polyéthylène téréphtalate (PET).

La couche d'oxyde conducteur transparent (11) est recouverte d'une couche continue (13) de matériau conducteur, par exemple en argent.

Des amas (12) en matériau (M) (splats) sont régulièrement répartis sur la face (111) de contact de la couche TCO (11) avec la couche de matériau conducteur (13). Ces splats (12) peuvent être par exemple en argent en particulier sous forme de nanoparticules, en oxyde de zinc en particulier sous forme de nanoparticules ou en polymère de type PEDOT : PSS.

L'agencement des splats (12) sur ladite surface (111) est plus particulièrement tel que décrit précédemment.

En particulier, en vue de dessus, comme représenté schématiquement en figure 3, les splats peuvent être régulièrement espacés pour former un maillage carré. La distance (d), centre à centre, entre deux splats voisins et leur diamètre (D) sont ajustés, en particulier au regard de la nature du matériau (M) formant les splats, comme décrit précédemment.

De préférence, le taux de recouvrement de la surface (111) par les splats (12) est compris entre 2 et 90 %, en particulier entre 7 et 80 %.

### APPLICATION

Comme évoqué précédemment, le procédé pour recouvrir une couche TCO d'une couche continue de matériau conducteur, en particulier d'argent, trouve une application particulièrement avantageuse pour la réalisation des contacts électriques au sein de dispositifs électroniques organiques.

Ainsi, la présente invention concerne encore, selon un autre de ses aspects, l'utilisation d'un procédé tel que défini précédemment pour réaliser un contact électrique au sein d'un dispositif électronique organique.

Le dispositif électronique organique peut être par exemple un dispositif photovoltaïque organique, par exemple un module photovoltaïque organique (module OPV) ou une diode électroluminescente organique (OLED pour « Organic Light-Emitting Diode » en langue anglaise).

Selon un mode de réalisation particulier, le procédé de l'invention peut être mis en oeuvre pour former la reprise de contact entre deux cellules adjacentes (notées cellule (n) et cellule (n+1)) d'un module photovoltaïque organique, par exemple d'un module photovoltaïque organique en structure inverse (NIP).

Selon encore un autre de ses aspects, la présente invention se rapporte à une dispositif électronique organique, en particulier un module OPV, et notamment un module OPV en configuration inversée, comprenant une structure multicouche telle que décrite précédemment ou obtenue selon le procédé détaillé ci-dessus.

L'élaboration d'un dispositif électronique organique, dans lequel un ou plusieurs contacts électriques sont réalisés selon le procédé de l'invention, relève des connaissances générales de l'homme du métier.

D'une manière générale, comme représenté en figure 2, dans le cas d'un module OPV en structure inverse, chacune des cellules du module est formée par formation, sur un substrat de base, en particulier en PET, des couches successives suivantes :
- une couche conductrice électrique en oxyde transparent conducteur (TCO), faisant fonction de première électrode ou électrode inférieure ;
- une couche semi-conductrice, transporteuse d'électrons, également appelée couche ETL (pour l'acronyme anglo-saxon « Electron Transport Layer ») ou encore « couche N » ;
- une couche active (CA) en matériau semi-conducteur organique ;
- une couche semi-conductrice, transporteuse de trous, également appelée HTL (pour l'acronyme anglo-saxon « Hole Transport Layer ») ou encore « couche P » ; et
- une couche conductrice, en particulier en argent, faisant fonction de seconde électrode ou d'électrode supérieure.

La zone de reprise de contact est la zone d'interconnexion électrique entre deux cellules adjacentes, correspondant à l'empilement de l'électrode supérieure de la cellule (n+1) avec l'électrode inférieure de la cellule (n).

Ainsi, le procédé de l'invention peut être plus particulièrement mis en oeuvre pour interconnecter, dans un module OPV en structure inverse, l'électrode inférieure en oxyde transparent conducteur d'une cellule (n) et l'électrode supérieure en matériau conducteur, en particulier en argent, de la cellule adjacente (n+1).

Les splats formés en surface de la couche TCO avant impression de l'électrode supérieure, en particulier en argent, peuvent être également formés au niveau de la surface libre du PET destinée à supporter l'électrode d'argent. Ils permettent là encore, comme illustré dans l'exemple 5 qui suit, de favoriser une bonne mouillabilité de la couche d'argent.

De manière avantageuse, l'élaboration d'un dispositif électronique organique selon l'invention peut se faire intégralement par voie humide, uniquement à l'aide de techniques de dépôt simples, aisément mises en oeuvre à l'échelle industrielle. Ainsi, à titre d'exemple, la couche N et la couche active peuvent être formées par « spin-coating » et la couche HTL, la précouche selon l'invention et l'électrode supérieure peuvent être formées par impression jet d'encre.

Comme évoqué précédemment, le matériau formant les splats peut être choisi parmi les matériaux formant les autres couches du dispositif électronique organique, et notamment, dans le cas d'un module OPV en structure inverse, parmi le matériau formant l'électrode supérieure, en particulier l'argent ; le matériau formant la couche semi-conductrice N tel que l'oxyde de zinc ; et le matériau formant la couche semi-conductrice P, tel qu'un polymère de type PEDOT : PSS.

Bien entendu, l'invention n'est pas limitée aux modules OPV décrits ci-dessus, et d'autres applications du procédé selon l'invention peuvent être envisagées.

L'invention va maintenant être décrite au moyen des exemples suivants donnés bien entendu à titre illustratif et non limitatif de l'invention.

### EXEMPLES

Dans tous les exemples qui suivent, les échantillons sont réalisés suivant la structure suivante :
Substrat PET / couche d'oxyde transparent conducteur (TCO) : oxyde d'indium dopé à l'étain (ITO) d'épaisseur de 300 nm/ précouche selon l'invention/ couche d'argent.

La préparation des empilements suit l'ordre suivant :
(1) Impression de la précouche ;
(2) Séchage de la précouche ;
(3) Impression de la couche supérieure d'argent ; et
(4) Séchage de la couche supérieure d'argent.

Sauf indication contraire, aucun traitement de surface n'est réalisé sur le substrat PET/oxyde conducteur.

### Réalisation de la précouche

Les amas (splats) sont formés par impression jet d'encre (imprimante Fujifilm Dimatix, cartouches 16 buses, volume nominal des gouttes 10 pL, impression sous conditions ambiantes).

Les splats sont solidifiés par séchage à 140 °C pendant 30 secondes, quelle que soit leur nature.

Les splats solidifiés sont disposés selon une maille carrée, comme représenté en figure 3.

L'espacement entre deux splats s'entend de la distance centre à centre (d) entre deux splats successifs. Il correspond à l'espacement des gouttes pulvérisées, prédéterminé par l'espacement entre les buses de la tête d'impression et de son orientation lors de l'impression.

Le diamètre (D) des splats s'entend du diamètre moyen de leur surface de contact avec la couche d'oxyde conducteur transparent. Ce diamètre est mesuré par microscopie optique après séchage des gouttes.

### Réalisation de la couche supérieure en argent

La couche supérieure en argent est réalisée par impression jet d'encre d'une dispersion de nanoparticules d'argent dans un mélange bisolvant (isopropanol et éthylène glycol.

La distance entre les splats pour l'impression de la couche supérieure d'argent est de 25 µm. Les gouttes d'argent s'étalent et coalescent pour former la couche supérieure.

La couche d'argent est séchée à 140 °C pendant 1 minute.

### EXEMPLE 1

### Réalisation d'une précouche de type N (ZnO)

Les splats en oxyde de zinc sont réalisés par impression jet d'encre d'une dispersion de nanoparticules d'oxyde de zinc dans un solvant de type alcool ou diol (éthanol, éthylène glycol ou un mélange des deux).

La formation de la couche d'argent sur la couche d'oxyde conducteur est testée :
(a) sans formation d'une précouche ;
(b) avec formation de splats de ZnO, de diamètre D de 140 µm et espacés d'une distance d de 140 µm ;
(c) avec formation de splats de ZnO, de diamètre D de 140 µm et espacés d'une distance d de 200 µm.

### Résultats

Les images, obtenues par observation au microscope optique sous lumière blanche des différents revêtements d'argent formés, sont présentées en figure 5.

Il apparaît clairement qu'un dépôt homogène et continu de l'encre argent n'est pas possible sur la couche de TCO seule (et ce quelle que soit la quantité d'argent déposée). En revanche, les images (b) et (c) montrent clairement l'affinité particulière de l'encre argent avec les splats de ZnO. La présence de la précouche de ZnO selon l'invention permet ainsi de réaliser une couche continue d'argent.

### EXEMPLE 2

### Réalisation d'une précouche de type argent

Les splats en argent sont réalisés par impression jet d'encre d'une dispersion de nanoparticules d'argent dans un solvant de type alcool ou diol (éthanol ou éthylène glycol).

La formation de la couche d'argent sur la couche d'oxyde conducteur est testée :
(a) sans formation d'une précouche ;
(b) avec formation des splats d'argent, de diamètre D de 30 µm et espacés d'une distance d de 50 µm.

### Résultats

L'observation des revêtements d'argent formés au microscope optique sous lumière blanche montre qu'en l'absence de traitement initial du TCO, l'encre argent mouille très mal la surface de TCO, alors qu'avec un dépôt préalable de splats selon l'invention, l'encre s'étale parfaitement en respectant le design souhaité.

Des essais similaires ont été menés en faisant varier l'espacement entre les splats d'argent formés, de 25 µm, 75 µm, 100 µm, 150 µm et 200 µm.

L'observation des couches d'argent formées dans le cadre de la mise en oeuvre de chacune de ces précouches montre qu'une couche d'argent continue est obtenue pour des splats espacés d'une distance centre à centre comprise entre 50 et 100 µm.

En dessous de 50 µm, les splats déposés ne sont plus suffisamment espacés et coalescent. Par conséquent, suite à l'impression de l'encre argent, le dépôt obtenu n'est pas continu.

Au-delà de 100 µm, les splats sont trop espacés et ne permettent pas d'obtenir une couche continue d'argent.

Pour un espacement des splats compris entre 50 et 100 µm, la couche supérieure en argent formée est continue. Par ailleurs, de manière avantageuse, pour un espacement des splats de 75 µm ou 100 µm, la couche d'argent formée est homogène, tandis qu'à 50 µm, le film d'argent est continu mais les splats sont visibles.

### EXEMPLE 3

### Réalisation d'une précouche de type P (polymère PEDOT : PSS)

Les splats en polymère PEDOT : PSS sont réalisés par impression jet d'encre d'une suspension de matrice polymères dans l'eau.

La mise en oeuvre des splats en polymère PEDOT : PSS, de diamètre D d'environ 40 µm et espacés d'une distance d de 50 µm permet d'imprimer des bandes continues d'argent de plusieurs centimètres.

Comme dans l'exemple 2, des essais réalisés avec un espacement variable entre les splats en polymère PEDOT : PSS (50 µm, 75 µm et 100 µm), montrent que pour un espacement des splats de 50 µm, la couche d'argent formée est continue et homogène. Pour un espacement de 75 µm, la couche d'argent semble continue macroscopiquement mais quelques défauts apparaissent de façon très localisée (taille des défauts d'environ 200-300 µm). Enfin, pour un espacement de 100 µm, le film d'argent est clairement discontinu.

### EXEMPLE 4

### Evaluation des performances électriques de la mise en oeuvre d'une précouche selon l'invention

Les performances électriques d'une couche d'argent sur une couche d'oxyde conducteur transparent (TCO) et sur le substrat PET, ont été testées pour différentes conditions de mise en oeuvre résumées dans le tableau 1 suivant.

La résistance carrée est mesurée à l'aide de la méthode dite des 4 pointes (équipement de mesure Napson).

**TABLEAU 1**

| **Essais** | **Traitement UVO₃** | **Précouche** | **espace entre gouttes d'argent déposées en µm** | **Résistance carrée (Ag sur TCO) en Ω sq⁻¹** | **Résistance carrée (Ag sur PET) en Ω sq⁻¹** |
|---|---|---|---|---|---|
| Essai 1 | oui | oui | (1) 25 | 1,9 | 1,9 |
| | | | (2) 25 | | |
| Essai 2 | non | non | (1) 25 | 15 (R_{TCO}) | > 10 kΩ sq⁻¹ |
| Essai 3 | non | oui | (1) 50 | 1,1 | 1,1 |
| | | | (2) 25 | | |

Le traitement « UVO₃ » est opéré sous éclairement UV en atmosphère fortement ozonée. De manière connue, ce traitement de surface permet d'améliorer l'état de surface du support traité, et notamment son potentiel de mouillabilité.

Après un traitement de surface « UVO₃ » de la couche de TCO et deux couches successives par jet d'encre avec un espacement de gouttes de 25 µm (permettant aux gouttes de coalescer entre elles), la résistance carrée mesurée est de 1,9 Ω sq⁻¹ (essai 1).

Sans traitement UVO₃ et pour une seule couche (essai 2), nous constatons que le contact électrique ne se fait pas puisque la résistance mesurée est celle du substrat (dépôt non homogène, cf exemple 2).

En réalisant un dépôt préalable de splats espacés de 50 µm (non coalescence) selon l'invention (essai 3), avant de déposer une couche homogène, la conductivité est bien meilleure (résistance carrée de 1,1 Ω sq⁻¹).

Les mêmes conclusions peuvent être faites dans le cas de l'impression de l'argent sur le substrat PET.

La résistivité diminue fortement (proportionnellement la conductivité augmente fortement) dans les deux cas de réalisation d'une précouche selon l'invention.

### EXEMPLE 5

### Evaluation de la mise en oeuvre de la précouche de splats selon l'invention pour former la reprise de contact dans un module OPV

Un module OPV a été réalisé intégrant une précouche d'argent, et les performances de ce module ont été comparées à un module « référence » intégrant une reprise de contact Cr-Au TCO réalisée de manière conventionnelle par évaporation sous vide.

Les dispositifs testés sont des modules PV organiques en structure dite « inverse » (NIP) et présentent la structure suivante :
Substrat PET / Oxyde conducteur / Couche N / Couche Active / Couche P / Argent
avec : Couche N = Oxyde de Zinc (ZnO)
Couche Active = poly(3-hexylthiophène)/[6,6]-phényl-C₆₁-butyrate de méthyle (P3HT /PCBM) ; et
Couche P = PEDOT:PSS (formulation « F010 » commercialisé par Heraeus).

Les différentes couches ont été mises en oeuvre par spin-coating sauf l'électrode d'argent qui a été mise en oeuvre par jet d'encre.

La surface active des dispositifs était de 11,04 cm² et leurs performances ont été mesurées à 25 °C dans des conditions standards d'éclairement (1 000 W/m², AM 1,5G).

Les résultats sont présentés dans le tableau 2 suivant :

**TABLEAU 2**

| **Type de reprise de contact** | **Voc (mV)** | **Jsc (mA cm⁻²)** | **FF(%)** | **PCE (%)** |
|---|---|---|---|---|
| Plot en Cr/Au | 1583 | 2,7 | 46 | 1,94 |
| Précouche Ag | 1592 | 2,4 | 51 | 1,98 |

| | | | | |
|---|---|---|---|---|
| V_{oc} : tension de circuit ouvert, J_{sc} : courant de court-circuit, FF : facteur de forme PCE : rendement de conversion énergétique. | | | | |

Les résultats présentés dans le tableau 2 montrent que le dépôt direct de l'argent sur le TCO *via* une précouche selon l'invention n'endommage pas les performances du système, et confirment le bon contact électrique entre les différentes cellules du module, comparativement à des reprises de contacts réalisées avec des plots de Cr-Au.

## Revendications

1. Procédé pour recouvrir une couche d'oxyde transparent conducteur d'une couche continue de matériau conducteur choisi parmi l'argent, le cuivre, l'or, l'aluminium et leurs mélanges, comprenant au moins les étapes consistant à :
(i) disposer d'une couche (11) d'oxyde transparent conducteur ;
(ii) constituer, à la surface de ladite couche (11), une pluralité d'amas (12) de matériau (M) *via* les étapes consécutives suivantes :
(a) dépôt de gouttes régulièrement réparties sur ladite surface, l'espacement entre deux gouttes voisines étant ajusté pour que les gouttes en s'étalant ne coalescent pas ;
lesdites gouttes étant formées d'un milieu liquide comprenant un matériau (M) dans un ou plusieurs solvants, et présentant une bonne mouillabilité vis-à-vis de l'oxyde transparent conducteur de la couche inférieure (11) et vis-à-vis du matériau conducteur destiné à former la couche continue supérieure ;
une bonne mouillabilité dudit milieu liquide vis-à-vis d'un matériau donné s'entendant d'un angle de contact, d'une goutte dudit milieu liquide déposée sur un support en ledit matériau, strictement inférieur à 90° ; et
(b) évaporation du ou desdits solvants contenu(s) dans les gouttes déposées pour former lesdits amas (12) de matériau (M) ;
le taux de recouvrement de la surface de ladite couche d'oxyde transparent conducteur par lesdits amas de matériau (M) étant ajusté pour garantir la formation d'une couche supérieure continue en matériau conducteur ; et
(iii) former à la surface de l'ensemble obtenu à l'issue de l'étape (ii) ladite couche (13) de matériau conducteur souhaitée.

2. Procédé selon la revendication 1, pour recouvrir une couche d'oxyde transparent conducteur d'une couche continue en argent.

3. Procédé selon la revendication 1 ou 2, dans lequel l'oxyde transparent conducteur est choisi parmi l'oxyde d'indium dopé à l'étain et l'oxyde de zinc éventuellement dopé, en particulier est l'oxyde d'indium dopé à l'étain.

4. Procédé selon l'une quelconque des revendications précédentes, dans lequel le dépôt des gouttes en étape (a) est opéré par impression jet d'encre.

5. Procédé selon l'une quelconque des revendications précédentes, dans lequel l'étape (b) est opérée par séchage, en particulier à une température comprise entre 50 et 250 °C, de préférence entre 100 et 140 °C, notamment pendant une durée allant de 10 secondes à 10 minutes.

6. Procédé selon l'une quelconque des revendications précédentes, dans lequel le taux de recouvrement de la surface de la couche d'oxyde transparent conducteur (11) par lesdits amas (12) en matériau (M) est compris entre 2 et 90 %, en particulier entre 7 et 80 %.

7. Procédé selon l'une quelconque des revendications 2 à 6, dans lequel le matériau (M) est choisi parmi l'argent en particulier sous forme de nanoparticules, l'oxyde de zinc en particulier sous forme de nanoparticules, et les polymères de type PEDOT : PSS.

8. Procédé selon l'une quelconque des revendications précédentes, dans lequel lesdits amas (12) de matériau (M) présentent un diamètre moyen (D) compris entre 20 µm et 200 µm, en particulier entre 25 µm et 150 µm, deux amas voisins étant espacés d'une distance (d), centre à centre, comprise entre 20 µm et 200 µm, en particulier entre 25 µm et 150 µm.

9. Procédé selon l'une quelconque des revendications 2 à 8, dans lequel ledit matériau (M) est l'argent, la disposition desdits amas (12) formés en étape (ii) étant telle que :
- le diamètre moyen (D) des amas est compris entre 20 et 100 µm, en particulier entre 25 et 50 µm, et
- la distance (d), centre à centre, entre deux amas voisins est comprise entre 50 et 100 µm, en particulier entre 75 et 100 µm.

10. Procédé selon l'une quelconque des revendications 2 à 8, dans lequel ledit matériau (M) est l'oxyde de zinc, la disposition desdits amas (12) formés en étape (ii) étant telle que :
- le diamètre moyen (D) des amas est compris entre 20 et 200 µm, en particulier entre 50 et 150 µm ; et
- la distance (d), centre à centre, entre deux amas voisins est comprise entre 50 et 200 µm, en particulier entre 100 et 200 µm.

11. Procédé selon l'une quelconque des revendications 2 à 8, dans lequel ledit matériau (M) est un polymère de type PEDOT : PSS, la disposition desdits amas (12) formés en étape (ii) étant telle que :
- le diamètre moyen (D) des amas est compris entre 20 et 100 µm, en particulier entre 40 et 80 µm, et plus particulièrement entre 50 et 80 µm; et
- la distance (d), centre à centre, entre deux amas voisins est comprise entre 20 et 200 µm, en particulier entre 50 et 80 µm.

12. Utilisation d'un procédé tel que défini selon l'une quelconque des revendications 1 à 11, pour réaliser un contact électrique au sein d'un dispositif électronique organique, notamment au sein d'un dispositif photovoltaïque organique ou une diode électroluminescente organique.

13. Utilisation selon la revendication 12, pour former la reprise de contact entre deux cellules adjacentes d'un module photovoltaïque organique.

14. Utilisation selon la revendication 12 ou 13, pour interconnecter, dans un module photovoltaïque organique en structure inverse, l'électrode inférieure en oxyde transparent conducteur d'une cellule (n) et l'électrode supérieure en matériau conducteur, en particulier en argent, de la cellule adjacente (n+1).

15. Utilisation selon la revendication 14, dans laquelle le matériau (M) formant lesdits amas (12) est choisi parmi le matériau formant l'électrode supérieure, en particulier l'argent, le matériau formant la couche semi-conductrice N, tel que l'oxyde de zinc, et le matériau formant la couche semi-conductrice P, tel qu'un polymère de type PEDOT :PSS.

16. Structure multicouche (1) présentant une couche (11) d'oxyde transparent conducteur surmontée d'une couche supérieure continue (13) de matériau conducteur choisi parmi l'argent, le cuivre, l'or, l'aluminium et leurs mélanges, **caractérisée en ce que** des amas (12) de matériau (M) sont régulièrement répartis sur la face (111) de contact de ladite couche d'oxyde transparent conducteur (11) avec la couche supérieure (13),
le matériau (M) étant tel qu'un milieu liquide comprenant ledit matériau (M) dans un ou plusieurs solvants présente une bonne mouillabilité vis-à-vis de l'oxyde transparent conducteur formant ladite couche inférieure (11) et vis-à-vis du matériau conducteur formant la couche continue supérieure (13) ;
une bonne mouillabilité dudit milieu liquide vis-à-vis d'un matériau donné s'entendant d'un angle de contact, d'une goutte dudit milieu liquide déposée sur un support en ledit matériau, strictement inférieur à 90° ;
le taux de recouvrement de la surface de la couche d'oxyde transparent conducteur par lesdits amas (12) étant compris entre 2 et 90 %, en particulier entre 7 et 80 %.

17. Structure multicouche selon la revendication précédente, dans laquelle ladite couche supérieure continue (13) est en argent, et le matériau (M) formant lesdits amas (12) est choisi parmi l'argent en particulier sous forme de nanoparticules, l'oxyde de zinc en particulier sous forme de nanoparticules, et les polymères de type PEDOT : PSS.

18. Structure multicouche selon la revendication 16 ou 17, dans laquelle l'agencement desdits amas (12) sur la face (111) de contact de ladite couche d'oxyde transparent (11) avec la couche supérieure (13) est tel que défini selon l'une quelconque des revendications 8 à 11.

19. Structure multicouche selon l'une quelconque des revendications 16 à 18, ladite structure étant obtenue selon le procédé tel que défini selon l'une quelconque des revendications 1 à 11.

20. Dispositif électronique organique, en particulier module photovoltaïque organique, et plus particulièrement module photovoltaïque organique en configuration inversée, comprenant au moins une structure multicouche selon l'une quelconque des revendications 16 à 19 ou obtenue selon le procédé tel que défini l'une quelconque des revendications 1 à 11.

## Patentansprüche

1. Verfahren zum Abdecken einer leitenden transparenten Oxidschicht mit einer durchgehenden Schicht aus leitendem Material, das ausgewählt ist unter Silber, Kupfer, Aluminium und ihren Gemischen, umfassend mindestens die folgenden Schritte, darin bestehend:
(i) eine Schicht (11) von leitendem transparentem Oxid aufzubringen;
(ii) an der Oberfläche der Schicht (11) eine Vielzahl von Anhäufungen (12) von Material (M) über die folgenden aufeinanderfolgenden Schritte zu bilden:
(a) Aufbringen von regelmäßig verteilten Tropfen auf die Oberfläche, wobei der Abstand zwischen zwei benachbarten Tropfen derart vorgesehen ist, dass sich die Tropfen, wobei sie sich verteilen, nicht miteinander verbinden;
wobei die Tropfen von einem flüssigen Medium gebildet sind, umfassend ein Material (M) in einem oder mehreren Lösungsmitteln, das eine gute Benetzbarkeit gegenüber dem leitenden transparenten Oxid der unteren Schicht (11) und gegenüber dem leitenden Material, das dazu bestimmt ist, die obere durchgehende Schicht zu bilden, aufweist;
wobei sich eine gute Benetzbarkeit des flüssigen Mediums gegenüber einem gegebenen Material um einen Kontaktwinkel von einem Tropfen des flüssigen Mediums ausgehend, der auf einen Träger aus dem Material aufgebracht ist, von unbedingt kleiner als 90° erstreckt; und
(b) Verdampfen des oder der Lösungsmittel(s), das(die) in den aufgebrachten Tropfen enthalten ist(sind), um die Anhäufungen (12) von Material (M) zu bilden;
wobei die Abdeckungsrate der Oberfläche der leitenden transparenten Oxidschicht durch die Materialanhäufungen (M) angepasst ist, um die Bildung einer durchgehenden oberen Schicht aus leitendem Material zu gewährleisten; und
(iii) an der Oberfläche der nach dem Schritt (ii) erhaltenen Gesamtheit die gewünschte Schicht (13) aus leitendem Material zu bilden.

2. Verfahren nach Anspruch 1 zum Abdecken einer leitenden transparenten Oxidschicht mit einer durchgehenden Schicht aus Silber.

3. Verfahren nach Anspruch 1 oder 2, bei dem das leitende transparente Oxid unter mit Zinn dotiertem Indiumoxid und eventuell dotiertem Zinkoxid ausgewählt ist, wobei das Oxid insbesondere mit Zinn dotiertes Indiumoxid ist.

4. Verfahren nach einem der vorhergehenden Ansprüche, bei dem das Aufbringen der Tropfen in Schritt (a) durch Tintenstrahldruck erfolgt.

5. Verfahren nach einem der vorhergehenden Ansprüche, bei dem der Schritt (b) durch Trocknen, insbesondere bei einer Temperatur zwischen 50 und 250 °C, vorzugswiese zwischen 100 und 140 °C, insbesondere während einer Dauer von 10 Sekunden bis 10 Minuten erfolgt.

6. Verfahren nach einem der vorhergehenden Ansprüche, bei dem die Abdeckungsrate der Oberfläche der leitenden transparenten Oxidschicht (11) durch die Anhäufungen (12) von Material (M) zwischen 2 und 90 %, ins besondere zwischen 7 und 80 %, beträgt.

7. Verfahren nach einem der Ansprüche 2 bis 6, bei dem das Material (M) unter Silber, insbesondere in Form von Nanopartikeln, Zinkoxid, insbesondere in Form von Nanopartikeln, und den Polymeren des Typs PEDOT : PSS ausgewählt ist.

8. Verfahren nach einem der vorhergehenden Ansprüche, bei dem die Anhäufungen (12) von Material (M) einen durchschnittlichen Durchmesser (D) zwischen 20 µm und 200 pm, insbesondere zwischen 25 µm und 150 µm, aufweisen, wobei benachbarte Anhäufungen um einen Abstand (d) von Mitte zu Mitte zwischen 20 µm und 200 µm, ins besondere zwischen 25 µm und 150 µm, beabstandet sind.

9. Verfahren nach einem der Ansprüche 2 bis 8, bei dem das Material (M) Silber ist, wobei die Anordnung der in Schritt (ii) gebildeten Anhäufungen (12) derart ist, dass:
- der durchschnittliche Durchmesser (D) der Anhäufungen zwischen 20 und 100 µm, insbesondere zwischen 25 und 50 µm, beträgt, und
- der Abstand (d) von Mitte zu Mitte zwischen zwei benachbarten Anhäufungen zwischen 50 und 100 µm, insbesondere zwischen 75 und 100 µm, beträgt.

10. Verfahren nach einem der Ansprüche 2 bis 8, bei dem das Material (M) Zinkoxid ist, wobei die Anordnung der in Schritt (ii) gebildeten Anhäufungen (12) derart ist, dass:
- der durchschnittliche Durchmesser (D) der Anhäufungen zwischen 20 und 200 µm, insbesondere zwischen 50 und 150 µm, beträgt, und
- der Abstand (d) von Mitte zu Mitte zwischen zwei benachbarten Anhäufungen zwischen 50 und 200 µm, insbesondere zwischen 100 und 200 µm, beträgt.

11. Verfahren nach einem der Ansprüche 2 bis 8, bei dem das Material (M) ein Polymer des Typs PEDOT : PSS ist, wobei die Anordnung der in Schritt (ii) gebildeten Anhäufungen (12) derart ist, dass:
- der durchschnittliche Durchmesser (D) der Anhäufungen zwischen 20 und 100 µm, insbesondere zwischen 40 und 80 µm, insbesondere zwischen 50 und 80 µm, beträgt, und
- der Abstand (d) von Mitte zu Mitte zwischen zwei benachbarten Anhäufungen zwischen 20 und 200 µm, insbesondere zwischen 50 und 80 µm, beträgt.

12. Verwendung eines Verfahrens, wie nach einem der Ansprüche 1 bis 11 definiert, um einen elektrischen Kontakt innerhalb einer organischen elektronischen Vorrichtung, insbesondere innerhalb einer organischen Photovoltaikanlage oder einer organischen Leuchtdiode, herzustellen.

13. Verwendung nach Anspruch 12, um die Wiederaufnahme eines Kontakts zwischen zwei aneinandergrenzenden Zellen eines organischen Photovoltaikmoduls zu bilden.

14. Verwendung nach Anspruch 12 oder 13, um in einem organischen Photovoltaikmodul in inverser Struktur die untere Elektrode aus leitendem transparentem Oxid einer Zelle (n) und die obere Elektrode aus leitendem Material, insbesondere Silber, der angrenzenden Zelle (n+1) zusammenzuschließen.

15. Verwendung nach Anspruch 14, bei der das Material (M), das die Anhäufungen (12) bildet, unter dem die obere Elektrode bildenden Material, insbesondere Silber, dem die Halbleiterschicht N bildenden Material, wie Zinkoxid, und dem die Halbleiterschicht P bildenden Material, wie einem Polymer des Typs PEDTO : PSS, ausgewählt ist.

16. Mehrschichtige Struktur (1), die eine leitende transparente Oxidschicht (11) aufweist, die auf einer durchgehenden oberen Schicht (13) aus leitendem Material, ausgewählt unter Silber, Kupfer, Gold, Aluminium und ihren Gemischen, montiert ist, **dadurch gekennzeichnet, dass** die Anhäufungen (12) von Material (M) regelmäßig auf der Kontaktfläche (111) der leitenden transparenten Oxidschicht (11) mit der oberen Schicht (13) verteilt sind,
wobei das Material (M) derart ist, dass ein flüssiges Medium, umfassend das Material (M) in einem oder mehreren Lösungsmitteln eine gute Benetzbarkeit gegenüber dem leitenden transparenten Oxid der unteren Schicht (11) und gegenüber dem leitenden Material, das die obere durchgehende Schicht (13) bildet, aufweist;
wobei sich eine gute Benetzbarkeit des flüssigen Mediums gegenüber einem gegebenen Material um einen Kontaktwinkel von einem Tropfen des flüssigen Mediums ausgehend, der auf einen Träger aus dem Material aufgebracht ist, von unbedingt kleiner als 90° erstreckt; und
wobei die Abdeckungsrate der Oberfläche der leitenden transparenten Oxidschicht durch die Anhäufungen (12) zwischen 2 und 90 %, insbesondere zwischen 7 und 80 %, beträgt.

17. Mehrschichtige Struktur nach dem vorhergehenden Anspruch, bei der die durchgehende obere Schicht (13) aus Silber ist, wobei das die Anhäufungen (12) bildende Material (M) unter Silber, insbesondere in Form von Nanopartikeln, Zinkoxid, insbesondere in Form von Nanopartikeln, und den Polymeren des Typs PEDOT : PSS ausgewählt ist.

18. Mehrschichtige Struktur nach Anspruch 16 oder 17, bei der die Anordnung der Anhäufungen (12) auf der Kontaktfläche (111) zwischen der transparenten Oxidschicht (11) mit der oberen Schicht (13), wie in einem der Ansprüche 8 bis 11, definiert ist.

19. Mehrschichtige Struktur nach einem der Ansprüche 16 bis 18, wobei die Struktur nach dem Verfahren, wie in einem der Ansprüche 1 bis 11 definiert, erhalten wird.

20. Organische elektronische Vorrichtung, insbesondere organisches Photovoltaikmodul und insbesondere organisches Photovoltaikmodul in inverser Konfiguration, umfassend mindestens eine mehrschichtige Struktur nach einem der Ansprüche 16 bis 19 oder, die nach dem Verfahren, wie in einem der Ansprüche 1 bis 11 definiert, erhalten wird.

## Claims

1. Process for covering a transparent conductive oxide layer with a continuous layer of conductive material chosen from silver, copper, gold, aluminium and mixtures thereof, comprising at least the steps consisting in:
(i) providing a transparent conductive oxide layer (11) ;
(ii) forming, at the surface of said layer (11), a plurality of clusters (12) of material (M) via the following consecutive steps:
(a) depositing evenly distributed drops on said surface, the spacing between two neighbouring drops being adjusted so that the drops do not coalesce on spreading;
said drops being formed of a liquid medium comprising a material (M) in one or more solvents, and having a good wettability with respect to the transparent conductive oxide of the lower layer (11) and with respect to the conductive material intended to form the continuous upper layer;
a good wettability of said liquid medium with respect to a given material being understood to mean having a contact angle, of a drop of said liquid medium deposited on a support made of said material, of strictly less than 90°; and
(b) evaporating said solvent(s) contained in the drops deposited in order to form said clusters (12) of material (M);
the degree of coverage of the surface of said transparent conductive oxide layer by said clusters of material (M) being adjusted in order to guarantee the formation of a continuous upper layer made of conductive material; and
(iii) forming, on the surface of the assembly obtained at the end of step (ii), said desired layer (13) of conductive material.

2. Process according to Claim 1, for covering a transparent conductive oxide layer with a continuous silver layer.

3. Process according to Claim 1 or 2, in which the transparent conductive oxide is selected from tin-doped indium oxide and optionally doped zinc oxide, and in particular is tin-doped indium oxide.

4. Process according to any one of the preceding claims, in which the deposition of the drops in step (a) is carried out by inkjet printing.

5. Process according to any one of the preceding claims, in which step (b) is carried out by drying, in particular at a temperature of between 50°C and 250°C, preferably between 100°C and 140°C, in particular for a duration ranging from 10 seconds to 10 minutes.

6. Process according to any one of the preceding claims, in which the degree of coverage of the surface of the transparent conductive oxide layer (11) by said clusters (12) of material (M) is between 2% and 90%, in particular between 7% and 80%.

7. Process according to any one of Claims 2 to 6, in which the material (M) is selected from silver, in particular in the form of nanoparticles, zinc oxide, in particular in the form of nanoparticles, and polymers of PEDOT:PSS type.

8. Process according to any one of the preceding claims, in which said clusters (12) of material (M) have a mean diameter (D) of between 20 µm and 200 µm, in particular between 25 µm and 150 µm, two neighbouring clusters being spaced apart by a distance (d), centre to centre, of between 20 µm and 200 µm, in particular between 25 µm and 150 µm.

9. Process according to any one of Claims 2 to 8, in which said material (M) is silver, the positioning of said clusters (12) formed in step (ii) being such that:
- the mean diameter (D) of the clusters is between 20 and 100 µm, in particular between 25 and 50 pm; and
- the distance (d), centre to centre, between two neighbouring clusters is between 50 and 100 µm, in particular between 75 and 100 µm.

10. Process according to any one of Claims 2 to 8, in which said material (M) is zinc oxide, the positioning of said clusters (12) formed in step (ii) being such that:
- the mean diameter (D) of the clusters is between 20 and 200 µm, in particular between 50 and 150 pm; and
- the distance (d), centre to centre, between two neighbouring clusters is between 50 and 200 µm, in particular between 100 and 200 µm.

11. Process according to any one of Claims 2 to 8, in which said material (M) is a polymer of PEDOT:PSS type, the positioning of said clusters (12) formed in step (ii) being such that:
- the mean diameter (D) of the clusters is between 20 and 100 µm, in particular between 40 and 80 µm, and more particularly between 50 and 80 pm; and
- the distance (d), centre to centre, between two neighbouring clusters is between 20 and 200 µm, in particular between 50 and 80 µm.

12. Use of a process as defined according to any one of Claims 1 to 11, for producing an electrical contact within an organic electronic device, in particular within an organic photovoltaic device or an organic light-emitting diode.

13. Use according to Claim 12, for establishing contact between two adjacent cells of an organic photovoltaic module.

14. Use according to Claim 12 or 13, for interconnecting, in an organic photovoltaic module of inverted structure, the lower electrode made of transparent conductive oxide of a cell (n) and the upper electrode made of conductive material, in particular made of silver, of the adjacent cell (n+1).

15. Use according to Claim 14, in which the material (M) forming said clusters (12) is selected from the material forming the upper electrode, in particular silver, the material forming the N semiconductor layer, such as zinc oxide, and the material forming the P semiconductor layer, such as a polymer of PEDOT:PSS type.

16. Multilayer structure (1) having a transparent conductive oxide layer (11) surmounted by a continuous upper layer (13) of conductive material selected from silver, copper, gold, aluminium and mixtures thereof, **characterized in that** clusters (12) of material (M) are evenly distributed on the contact face (111) of said transparent conductive oxide layer (11) with the upper layer (13),
the material (M) being such that a liquid medium comprising said material (M) in one or more solvents has a good wettability with respect to the transparent conductive oxide forming said lower layer (11) and with respect to the conductive material forming the continuous upper layer (13);
a good wettability of said liquid medium with respect to a given material being understood to mean having a contact angle, of a drop of said liquid medium deposited on a support made of said material, of strictly less than 90°;
the degree of coverage of the surface of the transparent conductive oxide layer by said clusters (12) being between 2% and 90%, in particular between 7% and 80%.

17. Multilayer structure according to the preceding claim, in which said continuous upper layer (13) is made of silver, and the material (M) forming said clusters (12) is chosen from silver, in particular in the form of nanoparticles, zinc oxide, in particular in the form of nanoparticles, and polymers of PEDOT:PSS type.

18. Multilayer structure according to Claim 16 or 17, in which the arrangement of said clusters (12) on the contact face (111) of said transparent oxide layer (11) with the upper layer (13) is as defined according to any one of Claims 8 to 11.

19. Multilayer structure according to any one of Claims 16 to 18, said structure being obtained according to the process as defined according to any one of Claims 1 to 11.

20. Organic electronic device, in particular organic photovoltaic module, and more particularly organic photovoltaic module of inverted configuration, comprising at least one multilayer structure according to any one of Claims 16 to 19 or obtained according to the process as defined in any one of Claims 1 to 11.
